(19) Europäisches Patentamt
European Patent Office
Office européen des brevets

(11) **EP 4 592 789 A2**

(12) **EUROPEAN PATENT APPLICATION**

(43) Date of publication:
30.07.2025 Bulletin 2025/31

(21) Application number: 25153281.8

(22) Date of filing: 22.01.2025

(51) International Patent Classification (IPC):
*G05F 1/56* (2006.01)      *G01R 31/40* (2020.01)
*G05F 1/575* (2006.01)

(52) Cooperative Patent Classification (CPC):
G05F 1/561; G01R 31/40; G05F 1/575

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 24.01.2024 CN 202410104420

(71) Applicant: Huawei Technologies Co., Ltd.
Shenzhen, Guangdong 518129 (CN)

(72) Inventors:
• ZHU, Xianpeng
  Shenzhen, 518129 (CN)
• KANG, Wenhong
  Shenzhen, 518129 (CN)
• WANG, Ye
  Shenzhen, 518129 (CN)
• SUN, Ke
  Shenzhen, 518129 (CN)

(74) Representative: Gill Jennings & Every LLP
The Broadgate Tower
20 Primrose Street
London EC2A 2ES (GB)

(54) **POWER SUPPLY CIRCUIT, ELECTRONIC DEVICE, AND CURRENT OVERSHOOT CONTROL METHOD**

(57)     This application provides a power supply circuit, an electronic device, and a current overshoot control method. The power supply circuit includes a drive module, a power transistor, and a voltage regulation module. In response to a first electrode voltage of a first electrode of the power transistor and a first reference voltage, the drive module controls a control voltage of a control electrode of the power transistor. In response to that the control voltage is not less than a preset voltage, the voltage regulation module controls a rise rate of the control voltage to decrease. In this way, the voltage regulation module may absorb electric energy at the control electrode, to control the rise rate of the control voltage to decrease, so that the control voltage no longer rises or slowly rises as the electric energy is absorbed, and a current in a power path remains unchanged or slowly increases. This can avoid a current overshoot in the power path.

FIG. 2

EP 4 592 789 A2

**Description**

TECHNICAL FIELD

This application relates to the field of power supply technologies, and in particular, to a power supply circuit, an electronic device, and a current overshoot control method.

BACKGROUND

When a power supply is tested, the power supply needs to be connected to an electronic load, to test whether the power supply can provide proper electric energy for the electronic load. Such a test may be referred to as a power supply test. When a power supply circuit in the electronic load is connected to the power supply, the power supply circuit can be regulated to control a voltage, a current, or a resistance output by the power supply, to test performance of the power supply in different states. In other words, to test whether the power supply can provide a large current instantaneously, for the power supply circuit, as a load, to instantaneously increase from a current of 0 to a target current, whether the power supply can provide such a current to the power supply circuit can be checked, that is, whether such a current exists on a power path, to meet a requirement of the power supply circuit, thereby implementing detection on a power supply capability of the power supply.

As a requirement on a power supply capability of the power supply for quickly responding to a large current increases, a current change rate (namely, di/dt) of a current output by the power supply per unit time has increased to 5000 A/$\mu$s. However, because a detection resistor in the power supply circuit has a parasitic inductance of hundreds of pf, a severe overshoot occurs in a pull current at large di/dt. This is inconsistent with an actual working scenario of the power supply.

SUMMARY

This application provides a power supply circuit, an electronic device, and a current overshoot control method, to avoid an overshoot of a current in a power path.

According to a first aspect, an embodiment of this application provides a power supply circuit. The power supply circuit may include a drive module, a power transistor, and a voltage regulation module. The drive module is separately connected to a control electrode of the power transistor, a first electrode of the power transistor, and the voltage regulation module. The drive module is configured to: in response to a first electrode voltage of the first electrode of the power transistor and a first reference voltage, control a control voltage of the control electrode of the power transistor. The first electrode of the power transistor is connected to a ground end, and a second electrode of the power transistor is configured to receive a power supply signal. The voltage regulation module is further connected to the control electrode of the power transistor, and the voltage regulation module is configured to: in response to that the control voltage is not less than a preset voltage, control a rise rate of the control voltage to decrease. A path formed after the power supply, the second electrode of the power transistor, the first electrode of the power transistor, and the ground end are connected is a power path. In this way, when electric energy output by the power supply is processed, the voltage regulation module may absorb electric energy at the control electrode of the power transistor, so that the control voltage at the control electrode of the power transistor no longer increases or slowly increases as the electric energy is absorbed, and the rise rate of the control voltage decreases. In addition, a conduction degree of the power transistor remains unchanged or slowly increases, so that a current in a power path finally remains unchanged or slowly increases. This avoids an excessive increase of the current in the power path in a transient state, thereby avoiding an overshoot of the current in the power path.

It should be understood that, when the power transistor is an N-type transistor, the control electrode may be a gate, the second electrode may be a drain, and the first electrode may be a source. When the power transistor is a P-type transistor, the control electrode may be a gate, the second electrode may be a source, and the first electrode may be a drain. This may be specifically set based on an actual requirement, and is not specifically limited herein.

Optionally, the voltage regulation module includes a switch unit, a voltage regulation unit, and an RC network, where a first end of the switch unit is connected to the control electrode of the power transistor, and a second end of the switch unit is separately connected to the voltage regulation unit and the RC network. The voltage regulation unit is configured to provide a second reference voltage for the second end of the switch unit, where the preset voltage is a sum of the second reference voltage and a conduction voltage drop of the switch unit. The switch unit is configured to: in response to that the control voltage is not less than the preset voltage, conduct the control electrode of the power transistor and the RC network; and in response to that the control voltage is less than the preset voltage, disconnect the control electrode of the power transistor from the RC network. The RC network is configured to: in response to that the control electrode of the power transistor and the RC network are conducted, control the rise rate of the control voltage to decrease; and in response to that the control electrode of the power transistor is disconnected from the RC network, skip controlling the rise rate of the control voltage. In this way, the switch unit may control whether to conduct the control electrode of the power transistor and the RC network, and further control whether to absorb the electric energy at the control electrode of the power transistor through the RC network, to avoid an overshoot of the current in the power path caused by an excessively large rise rate of the control voltage. In addition, the RC network does not always absorb the electric energy at the control electrode of the power transistor, but absorbs the electric energy at the control electrode of the power transistor only when the control electrode and the RC network are conducted. This helps avoid impact on a change rate (which may be represented as di/dt) of the current in the power path per unit time, and avoids an overshoot of the current in the power path when a di/dt requirement is met.

The preset voltage may be set to: when the power supply circuit is used in a power supply test scenario, a difference between a control voltage that is of a power transistor and that corresponds to a target current to be reached in a power supply test and a conduction voltage drop of the switch unit. For example, if the control voltage that is of the power transistor and that corresponds to the target current is represented by Vm, and the conduction voltage drop of the switch unit is represented by Va, the preset voltage may be Vm-Va, and the control voltage that is of the power transistor and that corresponds to the target current is a maximum value of the control voltage. In this case, the voltage regulation module can start to function only when the control voltage reaches the maximum value, so that the current in the power path can reach the target current. This can not only avoid impact on di/dt, but also avoid an overshoot of the current in the power path, thereby improving a power supply test effect. It should be understood that the control voltage that is of the power transistor and that corresponds to the target current may be obtained from a preconfigured correspondence table between a current and a control voltage, and the correspondence table may be obtained based on actual experience. The correspondence table is not specifically limited in embodiments of this application.

The switch unit may include a diode, a positive electrode of the diode is connected to the control electrode of the power transistor, and a negative electrode of the diode is connected to both the voltage regulation unit and the RC network. In this way, when the control voltage is not less than the preset voltage, the diode is turned on, and the control electrode of the power transistor and the RC network are conducted, so that the electric energy at the control electrode of the power transistor can be absorbed through the RC network. When the control voltage is less than the preset voltage, the diode is turned off, the control electrode of the power transistor is disconnected from the RC network, and the RC network does not absorb the electric energy at the control electrode of the power transistor, so that the diode can be used to control whether to absorb the electric energy at the control electrode of the power transistor through the RC network. A specific value of Va mentioned above may be determined based on a conduction voltage drop of the selected diode, for example, but is not limited to 0.7 V. This is not specifically limited herein.

The RC network may include a first resistor and a first capacitor. The first resistor and the first capacitor are connected in parallel between the second end of the switch unit and the ground end. In this way, when the diode is turned on, because the control voltage is higher than a ground voltage provided by the ground end, and the first capacitor is located between the control electrode and the ground end, a part of a current at the control electrode flows to the first capacitor to charge the first capacitor. In this way, the electric energy at the control electrode is absorbed, and a function of the RC network is implemented. In addition, when the diode is turned off, the first capacitor, the first resistor, and the ground end form a loop. The first capacitor releases electric energy via the first resistor until the electric energy is completely released, so that the electric energy at the control electrode is continued to be absorbed subsequently when the diode is turned on again.

The voltage regulation unit may include a first digital-to-analog conversion circuit and a linear voltage regulator, where the linear voltage regulator is connected between the first digital-to-analog conversion circuit and the second end of the switch unit. The first digital-to-analog conversion circuit is configured to output a third reference voltage to the linear voltage regulator. The linear voltage regulator is configured to: in response to the third reference voltage, provide the first reference voltage for the second end of the switch unit, so that the switch unit can determine whether to be turned on based on a value relationship between the control voltage and the preset voltage, to avoid an overshoot of the current in the power path. The first digital-to-analog conversion circuit may output the third reference voltage when processing the electric energy output by the power supply, to avoid an overshoot of the current in the power path. In addition, the first digital-to-analog conversion circuit does not output the third reference voltage when not processing the electric energy output by the power supply. This can reduce power consumption of the first digital-to-analog conversion circuit, and further reduce power consumption of the power supply circuit.

Optionally, the power supply circuit may further include a detection resistor, a voltage waveform regulation module, and a current collection module, where the voltage waveform regulation module is separately connected to a first end of the detection resistor, a second end of the detection resistor, and the current collection module. The first end of the detection resistor is further connected to the first electrode of the power transistor, and the second end of the detection resistor is connected to the ground end. The voltage waveform regulation module is configured to output a voltage signal to the current collection module after filtering voltages at two ends of the detection resistor. The current collection module is configured to: in response to a voltage signal output by the voltage waveform regulation module, collect a current flowing through the detection resistor. When the current in the power path is collected, a difference exists between the collected current and an actual current due to existence of a parasitic inductance of the detection resistor. A greater parasitic inductance indicates a greater difference. In this case, a finally collected current is inaccurate. Under an action of the voltage waveform regulation module, an inductance signal of a parasitic inductor may be filtered, to eliminate impact of the parasitic inductor, so that the collected current is closer to the actual current, and a collection error is reduced.

The voltage waveform regulation module may include a second resistor, a third resistor, and a second capacitor, where the second resistor is separately connected to the first end of the detection resistor, a first end of the second capacitor, and the current collection module, and the third resistor is separately connected to the second end of the detection resistor, a second end of the second capacitor, and the current collection module. In this way, a resistance value of the second resistor, a resistance value of the third resistor, and a capacitance value of the second capacitor are set to filter the inductance signal of the parasitic inductor, thereby eliminating impact of the parasitic inductor. It should be understood that the resistance value of the second resistor, the resistance value of the third resistor, and the capacitance value of the second capacitor may be specifically set based on an actual situation. This is not specifically limited herein.

Optionally, the current collection module may include a second operational amplifier and an analog-to-digital converter, where a positive input end of the second operational amplifier is separately connected to an end of the second resistor and the first end of the second capacitor, a negative input end of the second operational amplifier is separately connected to an end of the third resistor and the second end of the second capacitor, and an output end of the second operational amplifier is connected to the analog-to-digital converter. The second operational amplifier is configured to: determine a voltage difference between a voltage signal input from the positive input end and a voltage signal input from the negative input end, divide the voltage difference by a resistance value of the detection resistor, to determine a current signal, and output the current signal to the analog-to-digital converter. In this way, the analog-to-digital converter converts the received current signal into a current value, to implement current collection.

Optionally, the drive module may include a first operational amplifier, a regulation circuit, and a second digital-to-analog conversion circuit, where the regulation circuit is separately connected to the second digital-to-analog conversion circuit and a positive input end of the first operational amplifier, a negative input end of the first operational amplifier is separately connected to the first electrode of the power transistor and the first end of the detection resistor, and an output end of the first operational amplifier is connected to the control electrode of the power transistor. The second digital-to-analog conversion circuit is configured to: output a fourth reference voltage in response to processing the electric energy output by the power supply. The regulation circuit is configured to regulate the fourth reference voltage, to output a second reference voltage to the positive input end of the first operational amplifier, where the second reference voltage is a stable voltage value for the first operational amplifier to process the output voltage by using the second reference voltage as a reference. The first operational amplifier is configured to output a control voltage to the control electrode of the power transistor based on a comparison result, for example, a difference, between the second reference voltage and the output voltage (namely, the first electrode voltage of the power transistor). Therefore, the second digital-to-analog conversion circuit, the regulation circuit, and the first operational amplifier may collaborate to control the control voltage at the control electrode of the power transistor in response to processing the electric energy output by the power supply and the comparison result between the first electrode voltage of the first electrode of the power transistor and the second reference voltage. In addition, the fourth reference voltage may be determined based on a target current to be reached by the current in the power path, so that the control voltage corresponds to the target current.

Based on the foregoing structure, for example, the preset voltage is the sum of the first reference voltage and the conduction voltage drop of the diode. A working principle of the power supply circuit is as follows:

When the electric energy output by the power supply is processed, a voltage signal output by the output end of the first operational amplifier is a square wave signal. When a rising edge of the square wave signal arrives, that is, when processing starts, the control voltage of the power transistor increases rapidly. When the control voltage of the power transistor reaches a threshold voltage of the power transistor, the power transistor is turned on, and a conduction degree of the power transistor gradually increases as the control voltage increases. If the control voltage is less than the preset voltage, in this case, the diode is turned off, and the RC network does not function and does not absorb the voltage at the control electrode. Consequently, the current in the power path increases rapidly. If the voltage at the control electrode is not less than the preset voltage, the diode is turned on, and the RC network starts to function and absorb the electric energy at the control electrode, and charges the first capacitor in the RC network by using the absorbed current. In this case, the control voltage no longer increases or slowly increases as the electric energy is absorbed, and the current in the power path does not change or slowly increases. When the control voltage rises to the maximum value, the conduction degree of the power transistor is constant and remains unchanged, and the current in the power path no longer rises. In this way, an overshoot of the current in the power path is avoided in a dynamic case. In addition, as the first capacitor is fully charged, an absorption effect of the RC network reaches a limit, and the RC network no longer continues to absorb electric energy. When a falling edge of the square wave signal arrives, the control voltage gradually decreases until the control voltage is less than the preset voltage, and the diode changes from turn-on to turn-off. In this case, the first capacitor releases the stored electric energy via the first resistor. Then, the foregoing process is performed each time the rising edge and the falling edge of the square wave signal arrive.

Further, when a power supply capability of the power supply is tested, the maximum value of the control voltage may be determined based on the target current to be reached by the current in the power path, and the target current may be determined based on an actual test requirement. Therefore, the maximum value of the control voltage may be determined based on the target current. In addition, to ensure that the current rises rapidly and di/dt is not affected by the RC network in a test, the preset voltage may be dynamically set based on the maximum value of the control voltage. By adapting to a proper preset voltage, the RC network can function only when the control voltage reaches the maximum value. Therefore, the diode is turned on only when the control voltage reaches the maximum value. In this case, the RC network absorbs the electric energy at the control electrode, so that an objective of absorbing the overshoot without affecting rapid rise of the current can be achieved. In view of this, the maximum value of the control voltage may be dynamically set based on the target current, and the preset voltage is further dynamically set based on the maximum value of the control voltage, to ensure that the current rises rapidly and di/dt is not affected by the RC network. This improves a power supply test effect.

In addition, the second resistor, the third resistor, and the second capacitor form the voltage waveform regulation module to effectively filter out impact of the parasitic inductance in the detection resistor, so that the voltage signals transmitted to the positive input end and the negative input end of the second operational amplifier are voltage signals from which an inductance signal has been filtered out. In this way, the second operational amplifier can determine a current signal and output the current signal to the analog-to-digital converter, so that the analog-to-digital converter converts the received current signal into a current value, to collect a current. In addition, the collected current is closer to an actual current, and a collection error is reduced.

According to a second aspect, an embodiment of this application further provides a power supply circuit. The power supply circuit may include a drive module, a power transistor, and a voltage regulation module, where the drive module is separately connected to a control electrode of the power transistor, a first electrode of the power transistor, and the voltage regulation module, and the drive module is configured to: in response to a first electrode voltage of the first electrode of the power transistor and a first reference voltage, control a control voltage of the control electrode of the power transistor. The first electrode of the power transistor is connected to a ground end, and a second electrode of the power transistor is configured to receive a power supply signal. The voltage regulation module includes a switch unit, a voltage regulation unit, and an RC network, where a first end of the switch unit is connected to the control electrode of the power transistor, and a second end of the switch unit is separately connected to the voltage regulation unit and the RC network. The voltage regulation unit is configured to provide a second reference voltage for the second end of the switch unit, where the preset voltage is a sum of the second reference voltage and a conduction voltage drop of the switch unit. The switch unit is configured to: in response to that the control voltage is not less than the preset voltage, conduct the control electrode of the power transistor and the RC network, where the RC network is configured to: in response to that the control electrode of the power transistor and the RC network are conducted, control a rise rate of the control voltage to decrease.

In this way, when electric energy output by a power supply is processed, under an action of the switch unit, the voltage regulation unit, and the RC network, electric energy at the control electrode of the power transistor can be absorbed, so that the control voltage at the control electrode of the power transistor no longer increases or slowly increases as the electric energy is absorbed, and the rise rate of the control voltage decreases. In addition, a conduction degree of the power transistor remains unchanged or slowly increases, so that a current in a power path finally remains unchanged or slowly increases. This avoids an excessive increase of the current in the power path in a transient state, thereby avoiding an overshoot of the current in the power path.

Optionally, the power supply circuit further includes a detection resistor, a voltage waveform regulation module, and a current collection module, where the voltage waveform regulation module is separately connected to a first end of the detection resistor, a second end of the detection resistor, and the current collection module, the first end of the detection resistor is further connected to the first electrode of the power transistor, and the second end of the detection resistor is connected to the ground end. The voltage waveform regulation module includes a second resistor, a third resistor, and a second capacitor, where the second resistor is separately connected to the first end of the detection resistor, a first end of the second capacitor, and the current collection module, and the third resistor is separately connected to the second end of the detection resistor, a second end of the second capacitor, and the current collection module. The current collection module is configured to: in response to a signal processed by the voltage waveform regulation module, collect a current flowing through the detection resistor. In this way, under the action of the second resistor, the third resistor, and the second capacitor, inductance signals in collected voltages at the two ends of the detection resistor may be filtered, to eliminate impact of a parasitic inductance, so that a collected current is closer to an actual current, and a collection error is reduced.

It should be understood that, because a problem-resolving principle of the power supply circuit is similar to a problem-resolving principle of the foregoing power supply circuit, a structure of the power supply circuit is similar to that of the power supply circuit described in the first aspect. For example, but not limited to, for specific disposing manners of the drive module, the preset voltage, the switch unit, the RC network, the voltage regulation unit, and the current collection module, refer to the implementations and technical effects of the foregoing power supply circuit. Details are not described herein.

According to a third aspect, an embodiment of this application further provides a current overshoot control method. The method is implemented by using any one of the first aspect and the embodiments of the first aspect, or is implemented by using any one of the second aspect and the embodiments of the second aspect. The control method may include: In response to a first electrode voltage of a first electrode of a power transistor and a first reference voltage, a drive module controls a control voltage of a control electrode of the power transistor; and in response to that the control voltage is not less than a preset voltage, a voltage regulation module controls a rise rate of the control voltage to decrease. In this way, because the voltage regulation module absorbs the electric energy at the control electrode, the control voltage at the control electrode no longer increases or slowly increases as the electric energy is absorbed, and the rise rate of the control voltage decreases. In addition, a conduction degree of the power transistor remains unchanged or slowly increases, so that a current in a power path finally remains unchanged or slowly increases. This avoids an excessive increase of the current in the power path in a transient state, thereby avoiding an overshoot of the current in the power path.

Optionally, the control method may further include: The voltage waveform regulation module outputs a voltage signal to a current collection module after filtering voltages at two ends of a detection resistor; and in response to the voltage signal output by the voltage waveform regulation module, the current collection module collects a current flowing through the detection resistor. In this way, impact of a parasitic inductance in the detection resistor on the collected current can be eliminated, so that the collected current is closer to an actual current, and a collection error is reduced.

Optionally, the preset voltage may be: when the power supply circuit is used in a power supply test scenario, the voltage regulation module includes a switch unit, a voltage regulation unit, and an RC network, a first end of the switch unit is connected to the control electrode of the power transistor, and a second end of the switch unit is separately connected to the voltage regulation unit and the RC network, a difference between a control voltage that is of the power transistor and that corresponds to a target current to be reached in a power supply test and a conduction voltage drop of the switch unit. In this case, the control voltage that is of the power transistor and that corresponds to the target current is a maximum value of the control voltage. In this case, the voltage regulation module starts to function only when the control voltage reaches the maximum value, so that the current in the power path can reach the target current. This can not only avoid impact on di/dt, but also avoid an overshoot of the current in the power path, thereby improving a power supply test effect.

It should be understood that a problem-resolving principle of the control method is similar to a problem-resolving principle of the foregoing power supply circuit. Therefore, for implementation and technical effects of the control method, refer to the implementation and technical effects of the foregoing power supply circuit. Details are not described herein.

According to a fourth aspect, an embodiment of this application further provides an electronic device. The electronic device may include the power supply circuit described in any one of the first aspect and the embodiments of the first aspect, or any one of the second aspect and the embodiments of the second aspect, and a circuit board, where the power supply circuit is disposed on the circuit board and is electrically connected to the circuit board. In this way, when the electronic device is applied to a power supply test scenario, the electronic device may include an electronic load, and the electronic load may test a power supply capability of the power supply. When the electronic device is applied to a power supply scenario, the electronic device may include a device including a power supply, for example, a smartphone, a smart television, a smart television set-top box, a smart watch, a personal computer (personal computer, PC), a wearable device, or a smart broadband. Examples are not listed one by one herein. The power supply circuit in the electronic device may output stable electric energy, so that the electronic device can run normally.

It should be understood that a problem-resolving principle of the electronic device is similar to a problem-resolving principle of the foregoing power supply circuit. Therefore, for implementation and technical effects of the electronic device, refer to the implementation and technical effects of the foregoing power supply circuit. Details are not described herein.

BRIEF DESCRIPTION OF DRAWINGS

FIG. 1 is a diagram of a structure of an electronic device in the conventional technology;
FIG. 2 is a diagram of a structure of a power supply circuit according to an embodiment of this application;
FIG. 3 is a comparison diagram of power supply test effects;
FIG. 4 is a diagram of a structure of another power supply circuit according to an embodiment of this application;
FIG. 5 is a diagram of a relationship between a detection resistor and a parasitic inductor according to an embodiment of this application; and
FIG. 6 is a flowchart of a current overshoot control method according to an embodiment of this application.

DESCRIPTION OF EMBODIMENTS

To make the objectives, technical solutions, and advantages of this application clearer, the following further describes this application in detail with reference to the accompanying drawings.

It should be noted that identical reference numerals in the accompanying drawings of this application denote identical or similar structures. Therefore, repeated descriptions thereof are omitted. Expressions of positions and directions in embodiments of this application are described by using the accompanying drawings as examples. However, changes may also be made as required, and all the changes fall within the protection scope of this application. The accompanying drawings in this application are merely used to illustrate relative position relationships and do not represent an actual scale.

The technical solutions provided in embodiments of this application may be applied to various electronic devices, and the technical solutions provided in embodiments of this application may be applied to any scenario in which a high di/dt dynamic response needs to be implemented, for example, but not limited to a power supply test scenario or a power supply scenario. This is not specifically limited herein. In the power supply scenario, the electronic device may include but is not limited to a device including a power supply, for example, a smartphone, a smart television, a smart television set-top box, a smart watch, a personal computer, a wearable device, or a smart broadband. Examples are not listed one by one herein. The electronic device includes a power supply circuit, a power supply, and a power-consuming component. The power supply circuit processes electric energy output by the power supply, and then outputs processed electric energy to the power-consuming component, so that the power-consuming component can work normally, and normal operation of the electronic device is implemented.

In the power supply test scenario, the electronic device may include an electronic load, and the power supply is connected to the electronic load, to test whether the power supply can provide proper electric energy for the electronic load. This test may be referred to as a power supply test (which may also be referred to as a pull current test). The electronic load includes a power supply circuit. When the power supply circuit is connected to the power supply, the power supply circuit may be regulated to control a voltage, a current, or a resistance output by the power supply, to test performance of the power supply in different states. In other words, to test whether the power supply can provide a large current instantaneously, for the power supply circuit, as a load, to instantaneously increase from a current of 0 to a target current, check whether the power supply can provide such a current to the power supply circuit can be checked, that is, whether such a current exists on a power path, to meet a requirement of the power supply circuit, thereby implementing detection on a power supply capability of the power supply.

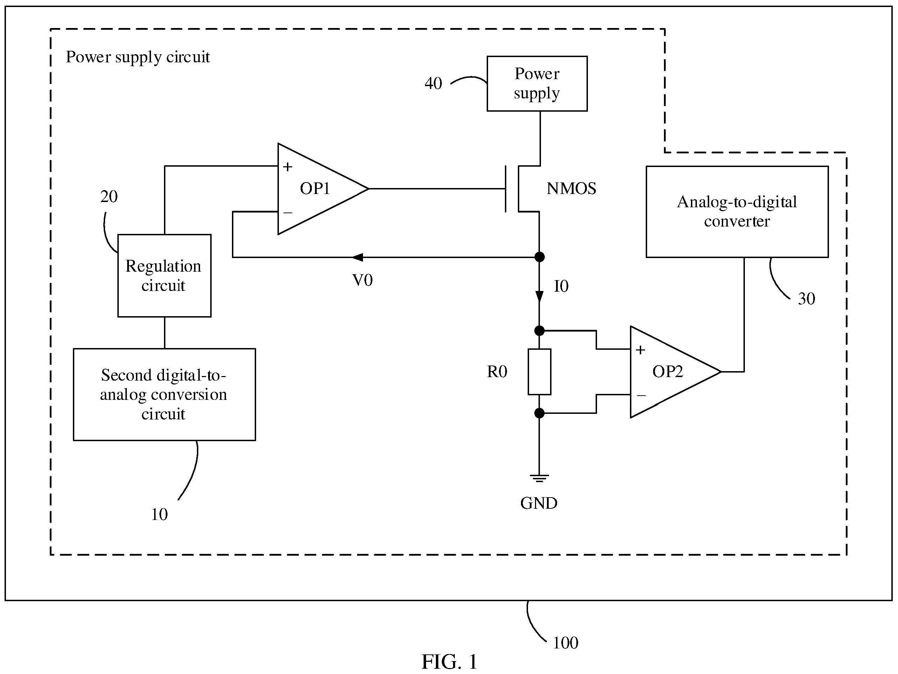

FIG. 1 is an example of a diagram of a structure of an electronic device in the conventional technology. Refer to FIG. 1. The electronic device may include a power supply circuit and a circuit board 100. The power supply circuit is disposed on the circuit board 100, and the power supply circuit is electrically connected to the circuit board 100 (an electrical connection relationship is not shown in FIG. 1). For example, the power supply circuit is used in a power supply test scenario. The power supply circuit includes a second digital-to-analog conversion circuit 10, a regulation circuit 20, a first operational amplifier OP1, a power transistor NMOS, a detection resistor R0, a second operational amplifier OP2, and an analog-to-digital converter 30. A gate of the power transistor NMOS is connected to an output end of the first operational amplifier OP1, a drain of the power transistor NMOS is connected to a power supply 40, and a source of the power transistor NMOS is separately connected to a negative input end of the first operational amplifier OP1, a first end of the detection resistor R0, and a positive input end of the second operational amplifier OP2. The regulation circuit 20 is separately connected to the second digital-to-analog conversion circuit 10 and a positive input end of the first operational amplifier OP1, a second end of the detection resistor R0 is separately connected to a ground end GND, and a negative input end of the second operational amplifier OP2, and an output end of the second operational amplifier OP2 is connected to the analog-to-digital converter 30.

In this case, the second digital-to-analog conversion circuit 10 is equivalent to a waveform generator, and is configured to output a fourth reference voltage in response to testing a power supply capability of the power supply 40. The regulation circuit 20 is configured to regulate the fourth reference voltage, to output a stable first reference voltage to the positive input end of the first operational amplifier OP1. The first operational amplifier OP1 is configured to output a gate voltage to the gate of the power transistor NMOS based on a difference between the first reference voltage and an output voltage V0. For the power transistor NMOS, when the gate voltage is less than a threshold voltage of the power transistor NMOS, the power transistor NMOS is turned off; and when a path formed by the source and the drain of the power transistor NMOS, the detection resistor R0, and the ground end GND is a power path, the power path is disconnected and no current passes through the power path. When the gate voltage is not less than the threshold voltage of the power transistor NMOS, the power transistor NMOS is turned on, so that the power path is conducted and a current I0 (namely, a pull current) passes through the power path, where the current I0 is provided by the power supply 40. The second operational amplifier OP2 is configured to: collect voltages at two ends of the detection resistor R0, and divide a determined voltage difference by a resistance value of the detection resistor R0 to obtain a current signal and transmit the current signal to the analog-to-digital converter 30. The analog-to-digital converter 30 is configured to convert the current signal into a current value to detect the current I0 in the power path and determine a pull current, so as to determine a power supply capability of the power supply 40.

As the current I0 passes through the power path, the output voltage V0 gradually increases, so that the gate voltage output by the first operational amplifier OP1 gradually increases, a conduction degree of the power transistor NMOS gradually increases, and the current I0 flowing through the power path increases accordingly. Therefore, a voltage may be fed back to the negative input end of the first operational amplifier OP1 based on the current in the power path, to regulate the gate voltage output by the first operational amplifier OP1, so that the current in the power path meets a requirement.

Currently, as a requirement on a power supply capability of the power supply 40 for quickly responding to a large current increases, a current change rate (namely, di/dt) of a current output by the power supply 40 per unit time has increased to 5000 A/$\mu$s. However, because the detection resistor R0 has a parasitic inductance of hundreds of pf, a severe overshoot occurs in the pull current at large di/dt. This is inconsistent with an actual working scenario of the power supply 40.

In view of this, to resolve the foregoing problem, an embodiment of this application provides a power supply circuit, to avoid an overshoot of the current I0 in the power path.

The following provides explanations and descriptions with reference to specific embodiments and by using an example in which the power transistor is an N-type transistor.

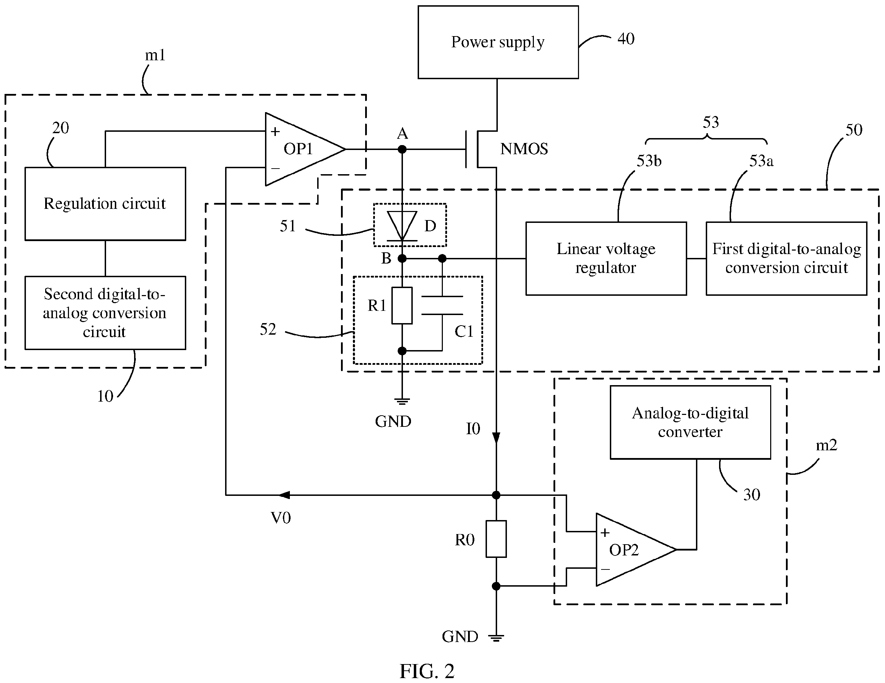

FIG. 2 is an example of a diagram of a structure of a power supply circuit according to this application. Refer to FIG. 2. The power supply circuit may include a drive module m1, a power transistor NMOS, a detection resistor R0, and a voltage regulation module 50. The drive module m1 is separately connected to a gate of the power transistor NMOS, a source of the power transistor NMOS, and the voltage regulation module 50. A drain of the power transistor NMOS is connected to a power supply 40, the source of the power transistor NMOS is further connected to a first end of the detection resistor R0, and a second end of the detection resistor R0 is connected to a ground end GND. The power supply 40, the drain of the power transistor NMOS, the source of the power transistor NMOS, the detection resistor R0, and the ground end GND may be sequentially connected to form a power path.

The drive module m1 includes a second digital-to-analog conversion circuit 10, a regulation circuit 20, and a first operational amplifier OP1. The regulation circuit 20 is separately connected to the second digital-to-analog conversion circuit 10 and a positive input end of the first operational amplifier OP1. A negative input end of the first operational amplifier OP1 is separately connected to the source of the power transistor NMOS and the first end of the detection resistor R0, and an output end of the first operational amplifier OP1 is separately connected to the gate of the power transistor NMOS and the voltage regulation module 50.

In this case, the second digital-to-analog conversion circuit 10 is configured to output a fourth reference voltage in response to processing electric energy output by the power supply 40. The regulation circuit 20 is configured to regulate the fourth reference voltage, to output a first reference voltage to the positive input end of the first operational amplifier OP1. The first operational amplifier OP1 is configured to output a gate voltage to the gate of the power transistor NMOS based on a comparison result, for example, a difference, between the first reference voltage and an output voltage V0. Therefore, the second digital-to-analog conversion circuit 10, the regulation circuit 20, and the first operational amplifier OP1 may collaborate to control the gate voltage of the power transistor NMOS in response to processing the electric energy output by the power supply 40 and the comparison result between the source voltage (namely, the output voltage V0) of the power transistor NMOS and the first reference voltage. The power transistor NMOS is configured to: be turned on in response to that the gate voltage is not less than a threshold voltage of the power transistor NMOS, so that the power path (namely, a path formed by sequentially connecting the power supply 40, the drain of the power transistor NMOS, the source of the power transistor NMOS, the detection resistor R0, and the ground end GND) is connected; and be turned off in response to that the gate voltage is less than the threshold voltage, so that the power path is disconnected. The voltage regulation module 50 is configured to: in response to that the gate voltage is not less than a preset voltage, control a rise rate of the gate voltage to decrease; and in response to that the gate voltage is less than the preset voltage, skip controlling the rise rate of the gate voltage. It should be understood that, during application in a power supply test scenario, processing the electric energy output by the power supply 40 includes testing a power supply capability of the power supply 40; or during application in a power supply scenario, processing the electric energy output by the power supply 40 includes regulating a voltage output by the power supply 40. In addition, when the gate voltage is not less than the preset voltage, the gate voltage is not less than the threshold voltage of the power transistor NMOS. Therefore, when the gate voltage is not less than the preset voltage, the power transistor NMOS is in a turn-on state.

In this way, when the electric energy output by the power supply 40 is processed, the voltage regulation module 50 may absorb electric energy at the gate of the power transistor NMOS, so that the gate voltage at the gate of the power transistor NMOS no longer increases or slowly increases as the electric energy is absorbed, and the rise rate of the gate voltage decreases. In addition, a conduction degree of the power transistor NMOS remains unchanged or slowly increases, so that a current I0 in the power path finally remains unchanged or slowly increases. This avoids an excessive increase of the current I0 in the power path in a transient state, thereby avoiding an overshoot of the current I0 in the power path.

The following describes a structure of the voltage regulation module 50.

The voltage regulation module 50 may include a switch unit 51, a voltage regulation unit 53, and an RC network 52. A first end of the switch unit 51 is connected to the gate of the power transistor NMOS, and a node at a joint is a node A. A second end of the switch unit 51 is separately connected to the voltage regulation unit 53 and the RC network 52, and a node at a joint is a node B. The voltage regulation unit 53 is configured to provide a second reference voltage for the second end (namely, the node B) of the switch unit 51, where the preset voltage is a sum of the second reference voltage and a conduction voltage drop of the switch unit 51. The switch unit 51 is configured to: in response to that the gate voltage of the power transistor NMOS is not less than the preset voltage, conduct the gate of the power transistor NMOS and the RC network 52, that is, conduct the node A and the node B; and in response to that the gate voltage of the power transistor NMOS is less than the preset voltage, disconnect the gate of the power transistor NMOS from the RC network 52, that is, disconnect the node A from the node B. The RC network 52 is configured to: in response to that the gate of the power transistor NMOS and the RC network 52 are conducted, that is, the node A and the node B are conducted, absorb the electric energy at the gate of the power transistor NMOS, where the electric energy may be understood as a current, to control the rise rate of the gate voltage of the power transistor NMOS to decrease; and in response to that the gate of the power transistor NMOS is disconnected from the RC network 52, that is, the node A and the node B are not conducted, skip absorbing the electric energy at the gate of the power transistor NMOS, to skip controlling the rise rate of the gate voltage of the power transistor NMOS. In this way, the switch unit 51 may control whether to conduct the gate of the power transistor NMOS and the RC network 52, and further control whether to absorb the electric energy at the gate of the power transistor NMOS through the RC network 52, to avoid an overshoot of the current I0 in the power path caused by an excessively large rise rate of the gate voltage. In addition, the RC network 52 does not always absorb the electric energy at the gate of the power transistor NMOS, but absorbs the electric energy at the gate of the power transistor NMOS only when the gate and the RC network 52 are conducted. This helps avoid impact on a change rate (which may be represented as di/dt) of the current I0 in the power path per unit time, and avoids an overshoot of the current I0 in the power path when a di/dt requirement is met.

The switch unit 51 may include a diode D. A positive electrode of the diode D is connected to the gate of the power transistor NMOS, and a negative electrode of the diode D is separately connected to the voltage regulation unit 53 and the RC network 52. In other words, the positive electrode of the diode D is connected to the node A, and the negative electrode of the diode D is connected to the node B. In this way, when the gate voltage is not less than the preset voltage, the diode D is turned on, so that the node A and the node B are conducted, and the gate of the power transistor NMOS and the RC network 52 are conducted. Therefore, the electric energy at the gate of the power transistor NMOS can be absorbed through the RC network 52. When the gate voltage is less than the preset voltage, the diode D is turned off, so that the node A and the node B are not conducted, the gate of the power transistor NMOS is disconnected from the RC network 52, and the RC network 52 does not absorb the electric energy at the gate of the power transistor NMOS. Therefore, the diode D may be used to control whether to absorb the electric energy at the gate of the power transistor NMOS through the RC network 52. When the switch unit 51 includes the diode D, the preset voltage may be set to: when the power supply circuit is used in the power supply test scenario, a difference between a gate voltage that is of the power transistor NMOS and that corresponds to a target current to be reached in a power supply test and a conduction voltage drop of the diode D. For example, the gate voltage that is of the power transistor NMOS and that corresponds to the target current is represented by Vm, and the conduction voltage drop of the diode D is represented by Va. In this case, the preset voltage may be Vm-Va. In addition, the gate voltage that is of the power transistor NMOS and that corresponds to the target current is a maximum value of the gate voltage. In this way, the voltage regulation module 50 may start to function only when the gate voltage reaches the maximum value, so that the current I0 in the power path can reach the target current in the power supply test. This can not only avoid impact on di/dt, but also avoid an overshoot of the current I0 in the power path, thereby improving a power supply test effect. A specific value of Va may be determined based on the selected diode D, for example, but is not limited to 0.7 V This is not specifically limited herein.

The RC network 52 may include a first resistor R1 and a first capacitor C1. The first resistor R1 and the first capacitor C1 are connected in parallel between the second end of the switch unit 51 and the ground end GND, that is, the first resistor R1 and the first capacitor C1 are connected in parallel between the node B and the ground end GND. In this way, when the diode D is turned on to conduct the node A and the node B, because a gate voltage at the node A is higher than a ground voltage provided by the ground end GND, and the first capacitor C1 is located between the node A and the ground end GND, a part of a current at the node A flows to the first capacitor C1 to charge the first capacitor C1, so as to absorb electric energy at the node A and implement a function of the RC network 52. In addition, when the node A is disconnected from the node B, the first capacitor C1, the first resistor R1, the node B, and the ground end GND form a loop. The first capacitor C1 releases electric energy via the first resistor R1 until the electric energy is completely released, so that the electric energy at the node A is continued to be absorbed subsequently when the node A and the node B are conducted again.

The voltage regulation unit 53 may include a first digital-to-analog conversion circuit 53a and a linear voltage regulator 53b. The linear voltage regulator 53b is connected between the first digital-to-analog conversion circuit 53a and the second end of the switch unit 51, that is, the linear voltage regulator 53b is connected between the first digital-to-analog conversion circuit 53a and the node B. The first digital-to-analog conversion circuit 53a is configured to output a third reference voltage to the linear voltage regulator 53b in response to processing the electric energy output by the power supply 40. The linear voltage regulator 53b is configured to: in response to the third reference voltage, provide the second reference voltage to the second end of the switch unit 51, so that the diode D can determine, based on a value relationship between the gate voltage and the preset voltage, whether to be turned on, to avoid an overshoot of the current I0 in the power path.

In view of this, a working principle of the power supply circuit may be as follows:

When the electric energy output by the power supply 40 is processed, a voltage signal output by the output end of the first operational amplifier OP1 is a square wave signal. When a rising edge of the square wave signal arrives, that is, when processing starts, the gate voltage (namely, a voltage at the node A) of the power transistor NMOS increases rapidly. When the gate voltage of the power transistor NMOS reaches a threshold voltage of the power transistor NMOS, the power transistor NMOS is turned on, and a conduction degree of the power transistor NMOS gradually increases as the gate voltage increases. If the voltage at the node A is less than a sum of a voltage at the node B and the conduction voltage drop of the diode D, it indicates that the gate voltage is less than the preset voltage. In this case, the diode D is turned off, and the RC network 52 does not function and does not absorb electric energy at the node A. Therefore, the current I0 in the power path increases rapidly. If the voltage at the node A is not less than the sum of the voltage at the node B and the conduction voltage drop of the diode D, it indicates that the gate voltage is not less than the preset voltage. In this case, the diode D is turned on, and the RC network 52 starts to function and absorb the electric energy at the node A. The first capacitor C1 in the RC network 52 is charged by using the absorbed electric energy, so that the voltage (namely, the gate voltage) at the node A does not increase or increases slowly as the electric energy is absorbed, that is, a voltage rise rate at the node A decreases. In this case, the current I0 in the power path does not change or slowly increases. When the gate voltage rises to the maximum value, the conduction degree of the power transistor NMOS is constant and remains unchanged, and the current I0 in the power path no longer rises. In this way, an overshoot of the current I0 in the power path is avoided in a dynamic case. In addition, as the first capacitor C1 is fully charged, an absorption effect of the RC network 52 reaches a limit, and the RC network 52 no longer continues to absorb electric energy. When a falling edge of the square wave signal arrives, the gate voltage gradually decreases until the gate voltage is less than the preset voltage, and the diode D changes from turn-on to turn-off. In this case, the first capacitor C1 releases the stored electric energy via the first resistor R1.

Further, when a power supply capability of the power supply 40 is tested, the maximum value of the gate voltage may be determined based on the target current to be reached by the current I0 in the power path, and the target current may be determined based on an actual test requirement. Therefore, the maximum value of the gate voltage may be determined based on the target current. In addition, to ensure that the current I0 rises rapidly and di/dt is not affected by the RC network 52 in a test, the preset voltage may be dynamically set based on the maximum value of the gate voltage, that is, the voltage at the node B is dynamically set based on the maximum value of the gate voltage at the node A. By adapting to a proper preset voltage, the RC network 52 can function only when the gate voltage reaches the maximum value, that is, the preset voltage is set to a difference between the maximum value of the gate voltage and the conduction voltage drop of the diode D. Therefore, the diode D is turned on only when the gate voltage reaches the maximum value. In this case, the RC network 52 absorbs the electric energy at the gate, so that an objective of absorbing the overshoot without affecting rapid rise of the current I0 can be achieved. In view of this, the maximum value of the gate voltage may be dynamically set based on the target current, and the preset voltage is further dynamically set based on the maximum value of the gate voltage, to ensure that the current I0 rises rapidly and di/dt is not affected by the RC network 52. This improves a test effect.

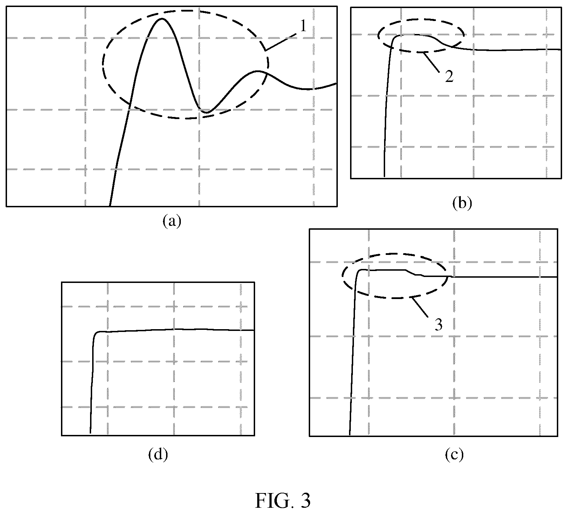

As shown in FIG. 3, (a) in the figure shows a current change in the power path when the power supply circuit in the conventional technology tests a power supply capability of the power supply 40, and (b) to (d) in the figure show current changes in the power path when the power supply circuit in this embodiment of this application tests the power supply capability of the power supply 40. It can be clearly seen from the figure that: When the voltage regulation module 50 is not disposed, an overshoot phenomenon of the current I0 in the power path is obvious, as shown in a dashed-line coil 1 in (a). Under the action of the voltage regulation module 50, an overshoot phenomenon of the current I0 in the power path is significantly improved, indicating that the overshoot of the current I0 is well suppressed, as shown in (b) to (d), and di/dt is not affected. In addition, current changes corresponding to different preset voltages are provided in FIG. (b) to FIG. (d), a preset voltage corresponding to FIG. (b) is greater than a preset voltage corresponding to FIG. (c), and a preset voltage corresponding to FIG. (c) is greater than a preset voltage corresponding to FIG. (d). The preset voltage corresponding to FIG. (d) is a difference between the maximum value of the gate voltage and the conduction voltage drop of the diode D. It can be learned from the results shown in FIG. (b) to FIG. (d) that, when the preset voltage is the difference between the maximum value of the gate voltage and the conduction voltage drop of the diode D, an overshoot phenomenon of the current can be effectively eliminated. When the preset voltage is greater than the difference between the maximum value of the gate voltage and the conduction voltage drop of the diode D, it indicates that when the gate voltage reaches the maximum value, the diode is still in a turn-off state, and the RC network does not absorb the electric energy at the gate. The diode is turned on only when the gate voltage reaches the sum of the preset voltage and the conduction voltage drop of the diode D. Therefore, the overshoot phenomenon of the current is also improved to a specific extent, as shown by a dashed-line coil 2 and a dashed-line coil 3.

For example, the power supply circuit may further include a current collection module m2, and the current collection module m2 may collect the current I0 in the power path. The current collection module m2 includes a second operational amplifier OP2 and an analog-to-digital converter 30. A positive input end of the second operational amplifier OP2 is connected to the first end of the detection resistor R0, a negative input end of the second operational amplifier OP2 is connected to the second end of the detection resistor R0, and an output end of the second operational amplifier OP2 is connected to the analog-to-digital converter 30. The second operational amplifier OP2 may collect voltages at two ends of the detection resistor R0, and divide a determined voltage difference by a resistance value of the detection resistor R0 to obtain a current signal. The analog-to-digital converter 30 converts the current signal into a current value to detect the current I0 in the power path and determine a pull current, so as to determine the power supply capability of the power supply 40.

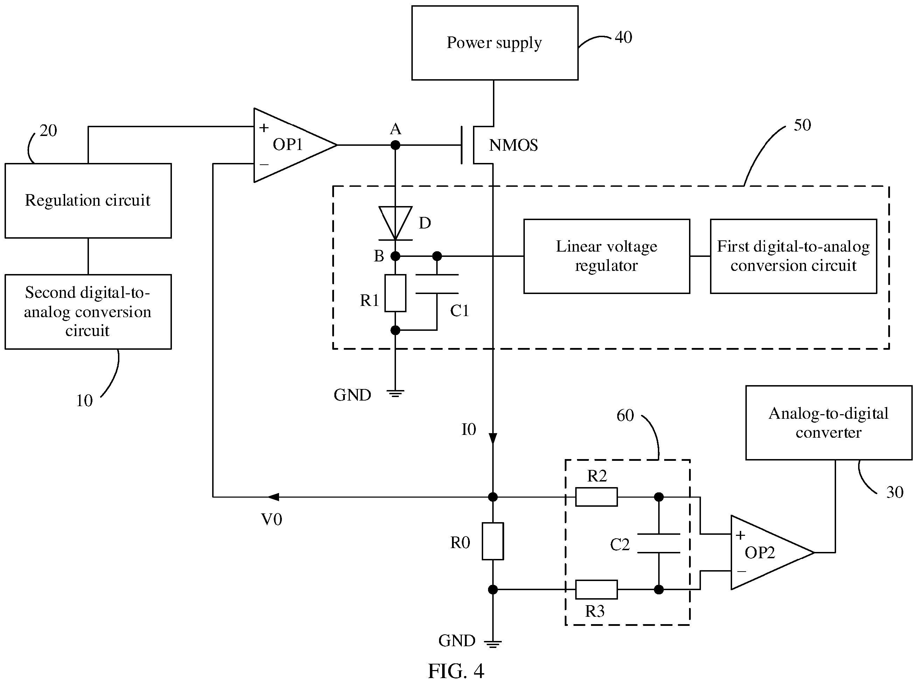

FIG. 4 is an example of a diagram of a structure of a power supply circuit according to this application. Refer to FIG. 4. A structure of the power supply circuit in this embodiment is basically similar to the structure of the power supply circuit in the embodiment shown in FIG. 2, and a difference lies in that: The power supply circuit further includes a voltage waveform regulation module 60. For example, the detection resistor R0 has a parasitic inductance, and the parasitic inductance is not shown in FIG. 4. When the current I0 in the power path is collected, because of the parasitic inductance, there is a difference between the collected current I0 and an actual current. A greater parasitic inductance indicates a greater difference. In this case, the finally collected current I0 is inaccurate. It should be understood that, because the current I0 in the power path changes, the collected current I0 may be considered as a dynamic current. In view of this, to resolve this problem, the power supply circuit may further include the voltage waveform regulation module 60. The voltage waveform regulation module 60 is separately connected to a first end of the detection resistor R0, a second end of the detection resistor R0, and a positive input end and a negative input end of the second operational amplifier OP2. The voltage waveform regulation module 60 is configured to separately output a voltage signal to the positive input end and the negative input end of the second operational amplifier OP2 after filtering voltages at two ends of the detection resistor R0. In other words, the voltage waveform regulation module 60 may filter an inductance signal in the voltages at the two ends of the detection resistor R0. The second operational amplifier OP2 determines a voltage difference between the positive input end and the negative input end, and then divides the voltage difference by a resistance value of the detection resistor R0, to determine a current signal and output the current signal to the analog-to-digital converter 30. In this case, the analog-to-digital converter 30 converts the received current signal into a current value to collect the current I0. After filtering is performed by the voltage waveform regulation module 60, the collected current I0 is closer to the actual current, and a collection error is reduced.

For example, when a power supply capability of the power supply 40 is tested, a gate voltage output by the first operational amplifier OP1 may be determined based on a relationship between the collected current and a preset target current. When a transient current of 5000 A/μs needs to be tested and a collected di/dt is also 5000 A/μs, in a case in which the voltage waveform regulation module 60 is not disposed, a collection error is large due to existence of the parasitic inductance. Therefore, the collected di/dt may be actually only 3500 A/μs. When the voltage waveform regulation module 60 is disposed, because impact of the parasitic inductance on the collected current is eliminated and the collection error is reduced, an actual di/dt may be closer to 5000 A/μs.

The voltage waveform regulation module 60 may include a second resistor R2, a third resistor R3, and a second capacitor C2. The second resistor R2 is separately connected to the first end of the detection resistor R0, a first end of the second capacitor C2, and the positive input end of the second operational amplifier OP2. The third resistor R3 is separately connected to the second end of the detection resistor R0, a second end of the second capacitor C2, and the negative input end of the second operational amplifier OP2. A resistance value of the second resistor R2, a resistance value of the third resistor R3, and a capacitance value of the second capacitor C2 are set to filter an inductance signal of a parasitic inductor, thereby eliminating impact of the parasitic inductor. It should be understood that the resistance value of the second resistor R2, the resistance value of the third resistor R3, and the capacitance value of the second capacitor C2 may be specifically set based on an actual situation. This is not specifically limited herein.

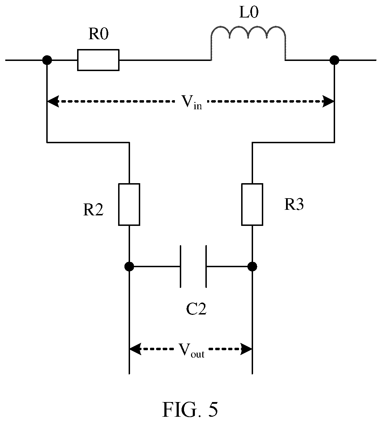

It should be noted that, with reference to FIG. 5, FIG. 5 shows an action mechanism of the second resistor R2, the third resistor R3, and the second capacitor C2, where L0 represents a parasitic inductor of the detection resistor R0, and the detection resistor R0 is connected in series to the parasitic inductor L0. If voltages at two ends after the detection resistor R0 is connected in series to the parasitic inductor L0 are denoted as Vin, Vin may satisfy the following relational expression 1:

$$V_{in} = R_s \times i(t) + L_s \times \frac{di(t)}{dt}.$$

In the foregoing relational expression 1, $R_s$ represents a resistance value of the detection resistor R0, i represents a current, t represents time, $L_s$ represents an inductance value of the parasitic inductor L0, and di(t)/dt represents a change rate of the current. After Laplace transform is performed on the relational expression 1, the following relational expression 2 may be obtained:

$$V_{in}(S) = R_s \times i(S) + S \times L_s \times i(S).$$

In the foregoing relational expression 2, S represents a complex variable in the Laplacian transform.

Similarly, if a voltage output after $V_{in}$ is filtered by the second resistor R2, the third resistor R3, and the second capacitor C2 is denoted as $V_{out}$, $V_{out}$ may satisfy the following relational expression 3:

$$V_{out}(S) = R_s \times i(S) \times (1 + S \times {}^{L_s}/_{R_s})/(1 + S \times C_f \times 2 \times R_f).$$

If $\frac{L_s}{R_s} = C_f \times 2 \times R_f$, where $C_f$ represents a capacitance value of the second capacitor C2, $R_f$ represents a resistance value of the second resistor R2, and the resistance value of the second resistor R2 is the same as the resistance value of the third resistor R3. When the relational expression is substituted into the foregoing relational expression 3, the following relational expression 4 may be obtained:

$$V_{out}(S) = R_s \times i(S).$$

It can be learned from the foregoing relational expression 4 that, at any sampling frequency, the voltage $V_{out}$ output after $V_{in}$ is filtered by the second resistor R2, the third resistor R3, and the second capacitor C2 is unrelated to the parasitic inductor L0 of the detection resistor R0. Because i(S) is a current value that changes with S, $V_{out}$ is only related to the resistance value of the detection resistor R0. Therefore, based on such a principle, when the voltage waveform regulation module 60 includes the second resistor R2, the third resistor R3, and the second capacitor C2, impact of the parasitic inductor L0 can be effectively filtered out, so that the collected current better conforms to the actual current, a collection error is reduced, and authenticity of collection is improved.

It should be understood that, for a similarity between the structure of the power supply circuit in this embodiment and the structure of the power supply circuit in the embodiment shown in FIG. 2, refer to related descriptions in the embodiment shown in FIG. 2. Details are not described herein.

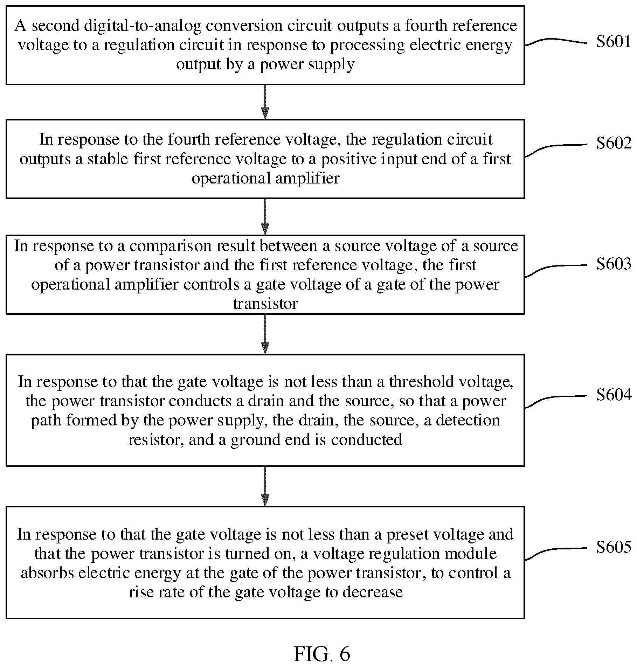

FIG. 6 is an example of a diagram of a current overshoot control method according to this application. Refer to FIG. 6. The control method may include the following steps.

S601: A second digital-to-analog conversion circuit outputs a fourth reference voltage to a regulation circuit in response to processing electric energy output by a power supply.

S602: In response to the fourth reference voltage, the regulation circuit outputs a stable first reference voltage to a positive input end of a first operational amplifier.

S603: In response to a comparison result between a source voltage of a source of a power transistor and the first reference voltage, the first operational amplifier controls a gate voltage of a gate of the power transistor.

S604: In response to that the gate voltage is not less than a threshold voltage, the power transistor conducts a drain and the source, so that a power path formed by the power supply, the drain, the source, a detection resistor, and a ground end is conducted.

S605: In response to that the gate voltage is not less than a preset voltage and that the power transistor is turned on, a voltage regulation module absorbs electric energy at the gate of the power transistor, to control a rise rate of the gate voltage to decrease.

In this way, when the electric energy output by the power supply is processed, the voltage regulation module may absorb the electric energy at the gate of the power transistor, so that the gate voltage at the gate of the power transistor no longer increases or slowly increases as the electric energy is absorbed, and the rise rate of the gate voltage decreases. In addition, a conduction degree of the power transistor remains unchanged or slowly increases, so that a current in the power path finally remains unchanged or slowly increases. This avoids an excessive increase of the current in the power path during transient load pulling, thereby avoiding an overshoot of the current in the power path.

Further, the control method may further include the following steps.

The voltage waveform regulation module separately inputs a voltage signal to the positive input end and a negative input end of the second operational amplifier after filtering voltages at the two ends of the detection resistor.

In response to voltage signals output by the positive input end and the negative input end, the second operational amplifier determines a current signal and inputs the current signal to an analog-to-digital converter.

In response to the received current signal, the analog-to-digital converter generates a corresponding current value.

In this way, current collection can be implemented. After filtering is performed by the voltage waveform regulation module, the collected current is closer to an actual current, and a collection error is reduced.

It is clearly that a person skilled in the art can make various modifications and variations to embodiments of this application without departing from the spirit and scope of embodiments of this application. This application is intended to cover these modifications and variations to embodiments of this application provided that they fall within the protection scope defined by the following claims and their equivalent technologies.

**Claims**

1. A power supply circuit, comprising a drive module, a power transistor, and a voltage regulation module, wherein

   the drive module is separately connected to a control electrode of the power transistor, a first electrode of the power transistor, and the voltage regulation module, and the drive module is configured to: in response to a first electrode voltage of the first electrode of the power transistor and a first reference voltage, control a control voltage of the control electrode of the power transistor;
   the first electrode of the power transistor is connected to a ground end, and a second electrode of the power transistor is configured to receive a power supply signal; and
   the voltage regulation module is further connected to the control electrode of the power transistor, and the voltage regulation module is configured to: in response to that the control voltage is not less than a preset voltage, control a rise rate of the control voltage to decrease.

2. The power supply circuit according to claim 1, wherein the voltage regulation module comprises a switch unit, a voltage regulation unit, and an RC network, wherein a first end of the switch unit is connected to the control electrode of the power transistor, and a second end of the switch unit is separately connected to the voltage regulation unit and the RC network;

   the voltage regulation unit is configured to provide a second reference voltage for the second end of the switch unit, wherein the preset voltage is a sum of the second reference voltage and a conduction voltage drop of the switch unit;
   the switch unit is configured to: in response to that the control voltage is not less than the preset voltage, conduct the control electrode of the power transistor and the RC network; and
   the RC network is configured to: in response to that the control electrode of the power transistor and the RC network are conducted, control the rise rate of the control voltage to decrease.

3. The power supply circuit according to claim 1 or 2, wherein the power supply circuit further comprises a detection resistor, a voltage waveform regulation module, and a current collection module, wherein the voltage waveform regulation module is separately connected to a first end of the detection resistor, a second end of the detection resistor, and the current collection module, the first end of the detection resistor is further connected to the first electrode of the power transistor, and the second end of the detection resistor is connected to the ground end;

   the voltage waveform regulation module is configured to output a voltage signal to the current collection module after filtering voltages at two ends of the detection resistor; and
   the current collection module is configured to: in response to the voltage signal output by the voltage waveform regulation module, collect a current flowing through the detection resistor.

4. The power supply circuit according to claim 3, wherein the voltage waveform regulation module comprises a second resistor, a third resistor, and a second capacitor, wherein the second resistor is separately connected to the first end of the detection resistor, a first end of the second capacitor, and the current collection module, and the third resistor is separately connected to the second end of the detection resistor, a second end of the second capacitor, and the current collection module.

5. A power supply circuit, comprising a drive module, a power transistor, and a voltage regulation module, wherein

   the drive module is separately connected to a control electrode of the power transistor, a first electrode of the power transistor, and the voltage regulation module, and the drive module is configured to: in response to a first electrode voltage of the first electrode of the power transistor and a first reference voltage, control a control voltage of the control electrode of the power transistor;
   the first electrode of the power transistor is connected to a ground end, and a second electrode of the power transistor is configured to receive a power supply signal;

the voltage regulation module comprises a switch unit, a voltage regulation unit, and an RC network, wherein a first end of the switch unit is connected to the control electrode of the power transistor, and a second end of the switch unit is separately connected to the voltage regulation unit and the RC network;

the voltage regulation unit is configured to provide a second reference voltage for the second end of the switch unit, wherein a preset voltage is a sum of the second reference voltage and a conduction voltage drop of the switch unit;

the switch unit is configured to: in response to that the control voltage is not less than the preset voltage, conduct the control electrode of the power transistor and the RC network; and

the RC network is configured to: in response to that the control electrode of the power transistor and the RC network are conducted, control a rise rate of the control voltage to decrease.

6. The power supply circuit according to claim 5, wherein the power supply circuit further comprises a detection resistor, a voltage waveform regulation module, and a current collection module, wherein the voltage waveform regulation module is separately connected to a first end of the detection resistor, a second end of the detection resistor, and the current collection module, the first end of the detection resistor is further connected to the first electrode of the power transistor, and the second end of the detection resistor is connected to the ground end;

the voltage waveform regulation module comprises a second resistor, a third resistor, and a second capacitor, wherein the second resistor is separately connected to the first end of the detection resistor, a first end of the second capacitor, and the current collection module, and the third resistor is separately connected to the second end of the detection resistor, a second end of the second capacitor, and the current collection module; and the current collection module is configured to: in response to a signal processed by the voltage waveform regulation module, collect a current flowing through the detection resistor.

7. The power supply circuit according to claim 5, or 6, wherein the preset voltage is: when the power supply circuit is used in a power supply test scenario, a difference between a control voltage that is of the power transistor and that corresponds to a target current to be reached in a power supply test and the conduction voltage drop of the switch unit.

8. The power supply circuit according to claim 5, 6, or 7, wherein the switch unit comprises a diode, a positive electrode of the diode is connected to the control electrode of the power transistor, and a negative electrode of the diode is separately connected to the voltage regulation unit and the RC network.

9. The power supply circuit according to claim 5, 6, 7, or 8, wherein the RC network comprises a first resistor and a first capacitor, and the first resistor and the first capacitor are connected in parallel between the second end of the switch unit and the ground end.

10. The power supply circuit according to claim 5, 6, 7, 8, or 9, wherein the voltage regulation unit comprises a first digital-to-analog conversion circuit and a linear voltage regulator, wherein the linear voltage regulator is connected between the first digital-to-analog conversion circuit and the second end of the switch unit;

the first digital-to-analog conversion circuit is configured to output a third reference voltage to the linear voltage regulator; and

the linear voltage regulator is configured to: in response to the third reference voltage, provide the second reference voltage for the second end of the switch unit.

11. A current overshoot control method, implemented via the power supply circuit according to any one of claims 1 to 10, wherein the control method comprises:

in response to a first electrode voltage of a first electrode of a power transistor and a first reference voltage, controlling, by a drive module, a control voltage of a control electrode of the power transistor; and

in response to that the control voltage is not less than a preset voltage, controlling, by a voltage regulation module, a rise rate of the control voltage to decrease.

12. The control method according to claim 11, further comprising:

outputting, by a voltage waveform regulation module, a voltage signal to a current collection module after filtering voltages at two ends of a detection resistor; and

in response to the voltage signal output by the voltage waveform regulation module, collecting, by the current collection module, a current flowing through the detection resistor.

13. The control method according to claim 11 or 12, wherein the preset voltage is: when the power supply circuit is used in a power supply test scenario, the voltage regulation module comprises a switch unit, a voltage regulation unit, and an RC network, a first end of the switch unit is connected to the control electrode of the power transistor, and a second end of the switch unit is separately connected to the voltage regulation unit and the RC network, a difference between a control voltage that is of the power transistor and that corresponds to a target current to be reached in a power supply test and a conduction voltage drop of the switch unit.

14. An electronic device, comprising the power supply circuit according to any one of claims 1 to 10 and a circuit board, wherein the power supply circuit is disposed on the circuit board and is electrically connected to the circuit board.

FIG. 1

FIG. 2

FIG. 3

FIG. 4

EP 4 592 789 A2

FIG. 5

A second digital-to-analog conversion circuit outputs a fourth reference voltage to a regulation circuit in response to processing electric energy output by a power supply ⟶ S601

In response to the fourth reference voltage, the regulation circuit outputs a stable first reference voltage to a positive input end of a first operational amplifier ⟶ S602

In response to a comparison result between a source voltage of a source of a power transistor and the first reference voltage, the first operational amplifier controls a gate voltage of a gate of the power transistor ⟶ S603

In response to that the gate voltage is not less than a threshold voltage, the power transistor conducts a drain and the source, so that a power path formed by the power supply, the drain, the source, a detection resistor, and a ground end is conducted ⟶ S604

In response to that the gate voltage is not less than a preset voltage and that the power transistor is turned on, a voltage regulation module absorbs electric energy at the gate of the power transistor, to control a rise rate of the gate voltage to decrease ⟶ S605

FIG. 6